(19) **Europäisches Patentamt / European Patent Office / Office européen des brevets**

(11) **EP 3 531 154 A1**

(12) # EUROPEAN PATENT APPLICATION

(43) Date of publication:
**28.08.2019 Bulletin 2019/35**

(21) Application number: **18158035.8**

(22) Date of filing: **22.02.2018**

(51) Int Cl.:
**G01R 33/24** (2006.01)    **G01R 33/44** (2006.01)
**G01R 33/48** (2006.01)    **G01R 33/50** (2006.01)
**G01R 33/561** (2006.01)    **G01R 33/565** (2006.01)
**G01R 33/563** (2006.01)    **G01R 33/567** (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(71) Applicant: **Koninklijke Philips N.V.**
**5656 AE Eindhoven (NL)**

(72) Inventors:
• **BECK, Gabriele**
  **5656 AE Eindhoven (NL)**
• **EGGERS, Holger**
  **5656 AE Eindhoven (NL)**

(74) Representative: **de Haan, Poul Erik et al**
**Philips International B.V.**
**Philips Intellectual Property & Standards**
**High Tech Campus 5**
**5656 AE Eindhoven (NL)**

(54) **DIXON MR IMAGING USING A MULTI-GRADIENT-ECHO SEQUENCE**

(57)    The invention relates to a method of MR imaging of an object. It is an object of the invention to provide a multi-gradient echo imaging technique with increased acquisition speed and intrinsic suppression of artefacts from Bo inhomogeneities, $T_2^*$ decay, chemical shift, motion, and/or flow, in particular in combination with radial or spiral k-space trajectories. The method of the invention comprises the steps of:
- subjecting the object (10) to an imaging sequence comprising RF excitation pulses and switched magnetic field gradients, wherein multiple echo signals are generated at different echo times after each RF excitation pulse,
- acquiring the echo signal data along radial or spiral k-space trajectories, wherefore the imaging sequence comprises magnetic field gradient blips in the x-/y- and/or z-directions;
- separating signal contributions from water and fat to the echo signals and estimating a Bo map and/or an apparent transverse relaxation time map ($T_2^*$ map) using a Dixon algorithm; and
- synthesizing an image of a specified contrast from the echo signal data, the Bo map and/or the $T_2^*$ map. Moreover, the invention relates to a MR device (1) and to a computer program for a MR device (1).

Fig. 2

**EP 3 531 154 A1**

**Description**

FIELD OF THE INVENTION

The invention relates to the field of magnetic resonance (MR) imaging. It concerns a method of MR imaging of an object placed in the examination volume of a MR device. The invention also relates to a MR device and to a computer program to be run on a MR device.

BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

According to the MR method in general, the body of the patient to be examined is arranged in a strong, uniform magnetic field Bo whose direction at the same time defines an axis (normally the z-axis) of the co-ordinate system to which the measurement is related. The magnetic field $B_0$ produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse) while the corresponding magnetic field $B_1$ of this RF pulse extends perpendicular to the z-axis, so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the magnetization is deflected from the z axis to the transverse plane (flip angle 90°).

After termination of the RF pulse, the magnetization relaxes back to the original state of equilibrium, in which the magnetization in the z direction is built up again with a first time constant $T_1$ (spin lattice or longitudinal relaxation time), and the magnetization in the direction perpendicular to the z direction relaxes with a second and shorter time constant $T_2$ (spin-spin or transverse relaxation time). The transverse magnetization and its variation can be detected by means of receiving RF coils which are arranged and oriented within an examination volume of the MR device in such a manner that the variation of the magnetization is measured in the direction perpendicular to the z-axis. The decay of the transverse magnetization is accompanied by dephasing taking place after RF excitation caused by local magnetic field inhomogeneities facilitating a transition from an ordered state with the same signal phase to a state in which all phase angles are uniformly distributed. The dephasing can be compensated by means of a refocusing RF pulse (for example a 180° pulse). This produces an echo signal (spin echo) in the receiving coils.

In order to realize spatial resolution in the body, time-varying magnetic field gradients extending along the three main axes are superposed on the uniform magnetic field Bo, leading to a linear spatial dependency of the spin resonance frequency. The signal picked up in the receiving coils then contains components of different frequencies which can be associated with different locations in the body. The signal data obtained via the receiving coils correspond to the spatial frequency domain and are called k-space data. The k-space data usually include multiple lines acquired with different phase encoding. Each line is digitized by collecting a number of samples. A set of k-space data is converted to an MR image by means of Fourier transformation.

Altbach et al. ("Radial Fast Spin-Echo Method for T2-Weighted Imaging and T2 Mapping of the Liver", J. Magn. Reson. Imaging, vol. 16, p. 179-189, 2002) describe a multishot radial fast spin echo (RAD-FSE) method developed to improve the quality of abdominal $T_2$-weighted imaging as well as the characterization of focal liver lesions. A novel radial k-space sampling scheme is used to minimize streaking artifacts due to $T_2$ variations and motion. Small diffusion gradients are applied to improve flow suppression. A post-processing algorithm is used to generate multiple high-resolution images (at different effective TE values) as well as a $T_2$ map from the echo signal data. The $T_2$ map is used to differentiate malignant from benign lesions.

Multi-echo re-combined gradient echo (MERGE) MR imaging is an imaging technique designed to image the cervical spine. In this technique, an imaging sequence, like a fast field echo (FFE) or echo planar imaging (EPI) sequence, is used, which comprises RF excitation pulses and switched magnetic field gradients, wherein multiple echo signals are generated at different echo times (TEs) after each RF excitation pulse. The echo signals can be generated, e.g., by alternating the polarity of the frequency-encoding gradient rapidly. The number of echo signals is limited by apparent transverse relaxation ($T_2^*$) decay. 3-10 echo signals can normally be acquired. Magnitude single echo images are reconstructed from the acquired echo signal data and summed (e.g. by a sums of squares algorithm) to obtain a 'merged' multi-echo image showing an increased gray/white matter contrast within the spinal cord and thereby to increase lesion conspicuity in the diagnosis of multiple sclerosis. Corresponding techniques are also known under the acronym MEDIC ('multi-echo data image combination').

A problem of the known merged multi gradient echo techniques is that the actual contrast in the combined images is governed by the selected sequence parameters, such as number of echoes, echo spacing, and voxel size, and is thereby limited by various sequence constraints. Moreover, patient motion and flow, as well as system imperfections are known to give rise to false positives in the detection of lesions with these methods.

Furthermore, especially in radial acquisition methods, the readout periods are relatively short compared to EPI or spiral acquisitions. Speed improvements using longer readout periods with a multiple echo readout trajectory are hence highly desirable.

SUMMARY OF THE INVENTION

From the foregoing it is readily appreciated that there is a need for an improved technique that overcomes the above problems. It is one object of the invention to enable merged multi gradient echo MR imaging with optimized contrast.

Moreover - and more generally - it is an object of the invention to provide a multi-echo imaging technique with increased acquisition speed and intrinsic suppression of artefacts from $B_0$ inhomogeneities, $T_2^*$ decay, chemical shift, motion, and/or flow, in particular in combination with radial or spiral acquisitions.

In accordance with the invention, a method of MR imaging of an object placed in the examination volume of a MR device is disclosed. The method comprises the steps of:

- subjecting the object to an imaging sequence comprising RF excitation pulses and switched magnetic field gradients, wherein multiple echo signals are generated at different echo times after each RF excitation pulse,
- acquiring the echo signal data along radial or spiral k-space trajectories, wherefore the imaging sequence comprises magnetic field gradient blips in the x-/y- and/or z-directions;
- separating signal contributions from water and fat to the echo signals and estimating a Bo map and/or an apparent transverse relaxation time map ($T_2^*$ map) using a Dixon algorithm; and
- synthesizing an image of a specified contrast from the echo signal data, the Bo map and/or the $T_2^*$ map.

According to the invention, multiple echo signals are acquired at different TEs. The echo signals are acquired along radial or spiral k-space trajectories. Radial or spiral k-space trajectories are preferred over conventional Cartesian k-space trajectories for their intrinsic motion robustness. Using radial or spiral k-space sampling, the center of k-space is oversampled and continuously updated. This redundancy can advantageously be exploited to detect and correct for motion, $B_0$ and $T_2^*$ effects.

To obtain a uniform k-space coverage, the rotation angle of the radial or spiral k-space trajectories is preferably incremented by the golden angle, $\Delta\Phi = 111.25°$, which corresponds to 180° multiplied by the golden ratio. Magnetic field gradient blips (short magnetic field gradient pulses applied between echo signal acquisition intervals after the same RF excitation pulse) in the x-/y- and/or z-directions are used according to the invention to obtain an optimum distribution of the acquired echo signal data in k-space at a fast acquisition speed. For the sake of simplicity, the x-/y-/z-directions refer here to the axes of the measurement coordinate system, i.e. the read-out/phase-encoding/slice-selection directions, which may or may not be aligned with the magnet coordinate system introduced above.

Since the blip encoding time between multiple echo readouts is limited, a tiny golden angle step is preferred for an optimal distribution. Covering at least half of k-space with the number of echoes acquired after the same RF excitation pulse guarantees a uniform distribution over time in 2D imaging. The method can also be adapted to a so-called pseudo golden angle enforcing the golden angle scheme on an equidistant radial grid. The tiny golden angle and pseudo golden angle are herein all regarded as falling under the general term 'golden angle'. In such golden angle schemes, subsequently sampled radial or spiral k-space trajectories always add complementary information while filling the largest gaps in k-space within the previously sampled set of k-space trajectories.

A Dixon algorithm is used according to the invention to separate contributions from water and fat to the acquired echo signals. In general such a separation is possible because there is a known precessional frequency difference of hydrogen in water and fat. In its simplest form, water and fat images are generated by either addition or subtraction of two echo signals, in which the water and fat signals are 'in-phase' and 'out-of-phase', respectively. In slightly more complex forms of the Dixon algorithm, a Bo map and/or a $T_2^*$ map is also extracted from the acquired echo signals.

The separation of water and fat and the estimation of a Bo map and a $T_2^*$ map provide flexibility in optimizing the contrast of the synthesized image for particular diagnostic purposes. $T_2^*$ results principally from inhomogeneities in the main magnetic field Bo. These inhomogeneities are the result of intrinsic inhomogeneities in the main magnetic field itself and of susceptibility-induced field distortions produced by the tissue. The latter type of Bo distortions determines the contrast of interest in $T_2^*$-weighted imaging. The influence of the former type of Bo inhomogeneities on $T_2^*$ is considered in the method of the invention to further increase the signal-to-noise ratio and/or enhance the contrast in the synthesized image.

The image is synthesized according to the invention from the acquired echo signal data, wherein a desired $T_2^*$ contrast can be chosen and Bo inhomogeneities and $T_2^*$ decay can be compensated for based on the corresponding maps derived from the acquired echo single data.

As a result, the invention enables an ultra-fast 3D radial or spiral (for example stack-of-stars or stack-of-spirals) acquisition with intrinsic Bo and $T_2^*$ mapping and water/fat separation.

The invention is of particular value in combination with the application of contrast agents, as the invention enables the reconstruction (synthesis) of an image with $T_1$-contrast and of an image with a desired $T_2^*$-contrast (as required for dynamic contrast-enhanced (DCE) MR imaging and dynamic susceptibility contrast (DSC) MR imaging) from the same echo signal data, which can be acquired according to the invention at a very high speed.

Furthermore, it is an insight of the invention that the combined image computed in the known MERGE/MEDIC technique can be considered as a $T_2^*$-weighted image at an effective echo time which is determined by the sequence parameters of the multi echo sequence, namely the number of echoes, the value of the first echo time in the sequence, the echo spacing and also $T_2^*$ itself. This insight opens up the possibility to synthesize an image having the desired contrast from the acquired echo signals and the $T_2^*$ map without any constraints imposed by the imaging sequence. Concurrently, the derived Bo map can be used to compensate for Bo inhomogeneity-induced image artefacts.

In a preferred embodiment of the invention, also a flow map is derived from the acquired echo signal data, wherein the flow map is used in the step of synthesizing the image for compensating for undesirable flow artefacts or to obtain a desired flow contrast.

In three-dimensional acquisitions, the phase encoding of the echo signals can be applied in the x-/y-direction only, the z-direction only, or simultaneously in the x-/y- and z-directions. Hence, in another preferred embodiment of the invention, the phase-encoding of the echo signals is varied in the z-direction while the rotation angle of the radial or spiral k-space trajectories is incremented by the golden angle increment in the $k_x$-/$k_y$-directions., wherein a uniform coverage of k-space in the $k_x$-/$k_y$-directions is achieved for every single $k_z$-step for a number of adjacent $k_z$-planes. The advantage is an improved motion characteristic.

Furthermore, for speeding up the acquisition, the sampling density in the $k_x$-/$k_y$-directions may vary as a function of $k_z$ such that a central portion of k-space, which comprises the most relevant information for image contrast, is sampled more densely than the peripheral portions. Hereby, at the peripheral portion of k-space phase encoding in only the z-direction can be performed, while moving towards the central portion of k-space, phase encoding in both x/y and z with a uniform distribution can be used. This variable density approach enables the possibility to extract 3D variable density image navigators from the 3D radial stack of stars data set.

In addition, a good distribution of echo times over k-space can be achieved by shifting x-/y- and z- encoding between successive RF excitations.

In order to facilitate image reconstruction, single echo images may be reconstructed from the echo signal data acquired at the respective echo time.

According to yet another preferred embodiment, a k-space weighted image contrast (KWIC) filter may be used for reconstructing the single echo images (see Song et al., Magn. Reson. Med., 44, 825-832, 2000). Moreover, compressed sensing maybe applied for reconstructing the single echo images or within the water/fat separation.

Moreover, a subset of the echo signals may be generated at an ultra-short echo time (UTE) (see Berker et al., J. Nucl. Med. 2012, 53, 796-804) to extend the range of accessible echo time values. Known partial echo techniques may be applied for this purpose as well. Echo shifting may alternatively or additionally be employed to improve the echo time coverage and to optimize the $T_2^*$ mapping.

In a further preferred embodiment of the invention, synthesizing the image of a specified contrast involves computing a zero echo time magnitude image and a $T_2^*$ map from the acquired echo signal data and applying a weighting to each voxel of the zero echo time magnitude image, which weighting is derived from the $T_2^*$ map. The weighting is calculated from the $T_2^*$ at the respective voxel location and from the effective echo time which is chosen to obtain the desired contrast. In this way, it can be achieved that the synthesized image resembles a conventional MERGE/MEDIC image (which is generated by magnitude reconstruction of single echo images from the acquired echo signals and combination of the single echo images, e.g., by a sum of squares algorithm) but without the constraints imposed on the contrast by the practically accessible range of sequence parameters.

Preferably, the imaging sequence used by the method of the invention is a fast/turbo field echo (FFE/TFE) or a balanced fast/turbo field echo sequence or an echo planar imaging (EPI) sequence or a spin echo sequence. These are proven techniques usable for fast and effective acquisition of echo signals at different echo times.

In another preferred embodiment of the invention, motion is detected from "intrinsic" data from one or more shots of the imaging sequence and motion-compensation is applied, in the separation of the signal contributions from water and fat, and/or in the synthesis of the image of a specified contrast. Hereby the 3D multi-echo, multi-shot variable density navigator approach allows improved "intrinsic" motion detection and correction possibilities using for example known compressed sensing methods, XD-GRASP or 3D elastic registration combination approaches.

The method of the invention described thus far can be carried out by means of a MR device including at least one main magnet coil for generating a uniform, steady magnetic field Bo within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The method of the invention can be implemented by a corresponding programming of the reconstruction unit and/or the control unit of the MR device.

The method of the invention can be advantageously carried out on most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

Fig. 1 shows a MR device for carrying out the method of the invention;
Fig. 2 shows a schematic (simplified) pulse sequence diagram of a multi-gradient echo MR imaging sequence according to the invention;
Fig. 3 illustrates an example of a k-space sampling pattern of the invention;
Fig. 4 shows an example of a merged multi-gradient echo image synthesized according to the invention.

DETAILED DESCRIPTION OF THE EMBODIMENTS

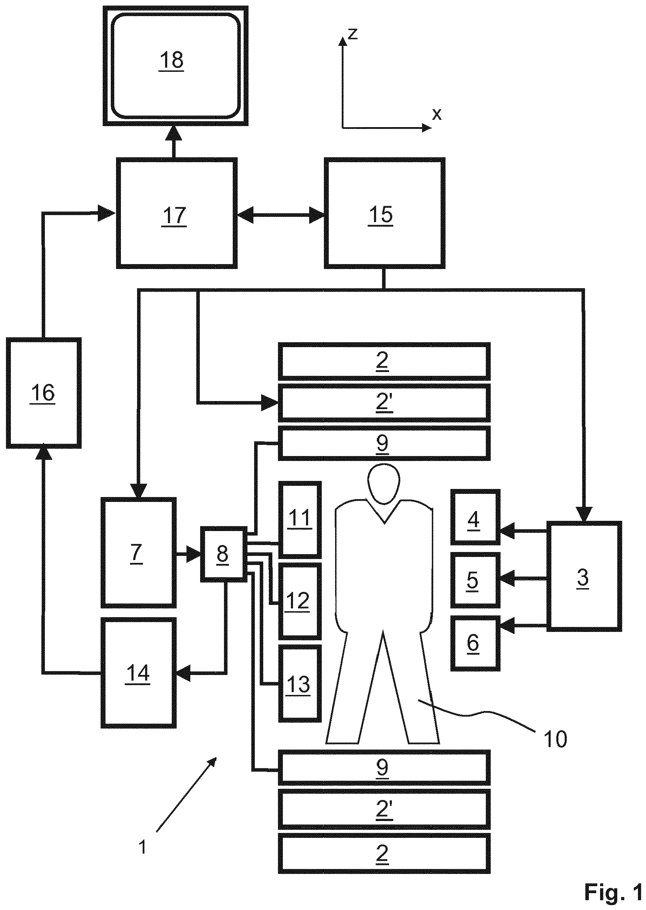

With reference to Fig. 1, a MR device 1 is shown as a block diagram. The device comprises superconducting or resistive main magnet coils 2 such that a substantially uniform, temporally constant main magnetic field Bo is created along a z-axis through an examination volume. The device further comprises a set of (1st, 2nd, and - where applicable - 3rd order) shimming coils 2', wherein the current flow through the individual shimming coils of the set 2' is controllable for the purpose of minimizing Bo deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient amplifier 3 applies current pulses or waveforms to selected ones of whole-body gradient coils 4, 5 and 6 along x, y and z-axes of the examination volume. A digital RF frequency transmitter 7 transmits RF pulses or pulse packets, via a send/receive switch 8, to a body RF coil 9 to transmit RF pulses into the examination volume. A typical MR imaging sequence is composed of a packet of RF pulse segments of short duration which, together with any applied magnetic field gradients, achieve a selected manipulation of nuclear magnetic resonance signals. The RF pulses are used to saturate resonance, excite resonance, invert magnetization, refocus resonance, or manipulate resonance and select a portion of a body 10 positioned in the examination volume. The MR signals are also picked up by the body RF coil 9.

For generation of MR images of limited regions of the body 10 or for scan acceleration by means of parallel imaging, a set of local array RF coils 11, 12, 13 are placed contiguous to the region selected for imaging. The array coils 11, 12, 13 can be used to receive MR signals induced by body coil RF transmissions.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via the send/receive switch 8.

A host computer 15 controls the shimming coils 2' as well as the gradient pulse amplifier 3 and the transmitter 7 to generate any of a plurality of MR imaging sequences, such as echo planar imaging (EPI), echo volume imaging, gradient and spin echo imaging, fast spin echo imaging, and the like. For the selected sequence, the receiver 14 receives a single or a plurality of MR signals in rapid succession following each RF excitation pulse. A data acquisition system 16 performs analog-to-digital conversion of the received signals and converts each MR data sample to a digital format suitable for further processing. In modern MR devices the data acquisition system 16 is a separate computer which is specialized in acquisition of raw image data.

Ultimately, the digital raw image data are reconstructed into an image representation by a reconstruction processor 17 which applies a Fourier transform or other appropriate reconstruction algorithms. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

The host computer 15 is programmed to execute the method of the invention described herein above and in the following.

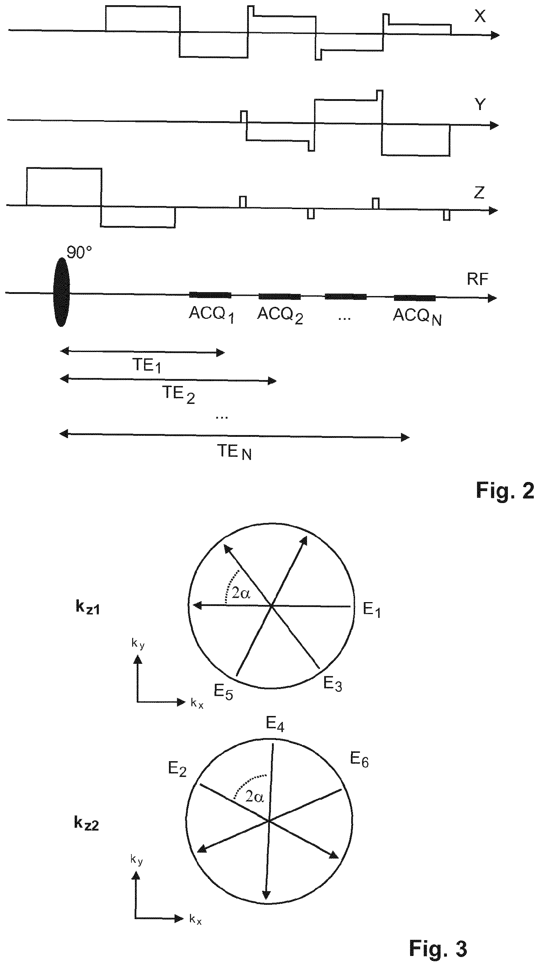

In Fig. 2, a schematic pulse sequence diagram of an imaging sequence according to the invention is depicted. The diagram shows switched magnetic field gradients in the read-out and phase-encoding directions x and y and in the slice-selection direction z. Moreover, the diagram shows an RF excitation pulse as well as the time intervals during which a number of echo signals are acquired, designated by $ACQ_1$, $ACQ_2$ and $ACQ_N$. The diagram covers the acquisition of $N$ echo signals. A plurality of sets of $N$ echo signals is acquired by multiple repetitions (shots) of the depicted sequence using different gradient waveforms in the x-/y-directions and/or in the z-direction in order to completely cover the required region of k-space by a radial sampling pattern. The timing and amplitudes of the readout gradients in the x-/y-directions are chosen such that different echo times $TE_1$, $TE_2$, ..., $TE_N$ are provided. Short magnetic field gradient blips are applied in addition to the actual read-out magnetic field gradients between the echo signal acquisition time intervals $ACQi$ - $ACQ_N$ in the x-/y-directions. Blips are also applied in the z-direction for achieving a Cartesian k-space sampling pattern in this direction (stack of stars). A very fast acquisition is achieved in this fashion with an optimum distribution of the acquired echo signal data in k-space.

As further illustrated in Figure 3, the phase-encoding of the echo signals is varied in the z-direction in a single shot while the rotation angle of the radial k-space trajectories is incremented by the golden angle increment in the $k_x$-/$k_y$-directions. In the example of Figure 3, the magnetic field gradient blips in the z-direction (as shown in Figure 2) result in k-space being sampled alternatingly in two adjacent $k_z$-planes (designated by $k_{z1}$ and $k_{z2}$). The sequence of echo signals acquired in a single shot of the imaging sequence is designated as $E_1$, ..., $E_6$. Echo signal $E_1$ is acquired initially from plane $k_{z1}$, the rotation angle of the radial k-space profile is then incremented by the tiny golden angle $\alpha$ and the next echo signal $E_2$ is sampled from plane $k_{z2}$. The rotation angle is again incremented by alpha, the next echo signal $E_3$ is acquired again from plane $k_{z1}$, and so forth. The rotation angle increment between two consecutive k-space profiles acquired from the same plane is thus $2\alpha$. A sufficiently high sampling density in the $k_x$-$k_y$-plane may thus not be achieved for every single $k_z$-plane, but for a number of adjacent $k_z$-planes. The acquisition speed can be increased significantly in this manner without relevant negative impact on final image quality.

As an intermediate step, single echo images may be reconstructed from the acquired echo signal data: A first single echo image attributed to the first echo time $TE_1$, a second single echo image attributed to the second echo time $TE_2$, and so forth. The contributions from water and fat to the respective voxel values are separated by application of a Dixon algorithm of known type on the basis of the different echo times $TE_1$, ..., $TE_N$. At the same time, a $T_2^*$ map is estimated by including the $T_2^*$ decay in the signal model employed in the Dixon algorithm. Alternatively, the separation of water and fat and the estimation of $T_2^*$ may be performed directly on the acquired echo signal data without explicitly reconstructing single echo images.

Depending on the type of combination, the images resulting from the known MERGE or MEDIC methods can be described by:

$$S_1 = \sum_{n=1}^{N} S\, e^{-TE_n/T_2^*}, \qquad\qquad (1)$$

$$S_2 = \sum_{n=1}^{N} \left(S\, e^{-TE_n/T_2^*}\right)^2, \qquad\qquad (2)$$

$$S_3 = \sqrt{\sum_{n=1}^{N} \left(S\, e^{-TE_n/T_2^*}\right)^2}, \qquad\qquad (3)$$

$$S_4 = \frac{1}{N} \sqrt{\sum_{n=1}^{N} \left(S\, e^{-TE_n/T_2^*}\right)^2}, \qquad\qquad (4)$$

wherein $N$ denotes the number of echoes and S denotes a voxel value of the resulting images.

Assuming a constant echo spacing $\Delta TE$, Eq. (1) can be rewritten as:

$$S_1 = S\, e^{-TE_1/T_2^*} \sum_{n=1}^{N} e^{-(n-1)\Delta TE/T_2^*}, \tag{5}$$

$$S_1 = S\, e^{-TE_1/T_2^*}\, \frac{1-e^{-N\,\Delta TE/T_2^*}}{1-e^{-\Delta TE/T_2^*}}. \tag{6}$$

This allows introducing an effective echo time $TE_{1e}$:

$$S_1 = S\, e^{-TE_{1e}/T_2^*}, \tag{7}$$

given by:

$$e^{-TE_{1e}/T_2^*} = e^{-TE_1/T_2^*}\, \frac{1-e^{-N\,\Delta TE/T_2^*}}{1-e^{-\Delta TE/T_2^*}}, \tag{8}$$

$$TE_{1e} = TE_1 - T_2^* \ln\left(\frac{1-e^{-N\,\Delta TE/T_2^*}}{1-e^{-\Delta TE/T_2^*}}\right). \tag{9}$$

Similarly, the combined images $S_2$, $S_3$, $S_4$ can be computed using effective echo times given by:

$$TE_{2e} = 2\,TE_1 - T_2^* \ln\left(\frac{1-e^{-2N\,\Delta TE/T_2^*}}{1-e^{-2\,\Delta TE/T_2^*}}\right), \tag{10}$$

$$TE_{3e} = TE_1 - \frac{T_2^*}{2} \ln\left(\frac{1-e^{-2N\,\Delta TE/T_2^*}}{1-e^{-2\,\Delta TE/T_2^*}}\right), \tag{11}$$

$$TE_{4e} = TE_1 + T_2^* \ln(N) - \frac{T_2^*}{2} \ln\left(\frac{1-e^{-2N\,\Delta TE/T_2^*}}{1-e^{-2\,\Delta TE/T_2^*}}\right), \tag{12}$$

It is thus the insight of the invention that the images resulting from the MERGE or MEDIC methods can be considered as $T_2^*$-weighted images, wherein the effective echo time is indirectly determined by the selected number of echoes, the first echo time, and the echo spacing, but also, and most remarkably, by $T_2^*$.

To overcome the only indirect determination of the effective echo time and any constraints on the imaging sequence, the invention proposes to first estimate a $T_2^*$ map from the echo signal data and to then synthesize an image from the estimated zero echo time magnitude image and the $T_2^*$ map. The separation of water and fat may be included optionally to provide even more flexibility in optimizing the contrast in the resulting images depending on the particular diagnostic purposes.

To overcome the sensitivity of the known MERGE/MEDIC methods to motion, it is proposed to employ radial or spiral k-space trajectories instead of conventional Cartesian k-space trajectories. Preferably, a projection or interleaf order based on the golden angle is used, and an incremental rotation by a tiny golden angle is applied between successive radial or spiral acquisitions. Additionally, inconsistent data may optionally be rejected and motion may optionally be detected and corrected between the individual acquisitions.

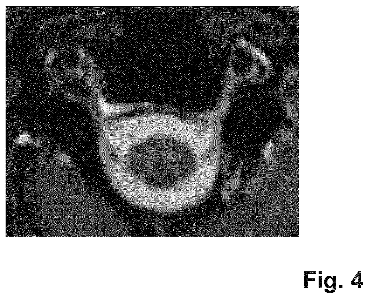

Fig. 4 shows an exemplary image of the spinal cord synthesized by the method of the invention. The image allows excellent differentiation between gray and white matter.

## Claims

1. Method of MR imaging of an object (10) positioned in the examination volume of a MR device (1), the method comprising the steps of:

- subjecting the object (10) to an imaging sequence comprising RF excitation pulses and switched magnetic field gradients, wherein multiple echo signals are generated at different echo times after each RF excitation pulse,
- acquiring the echo signal data along radial or spiral k-space trajectories, wherefore the imaging sequence comprises magnetic field gradient blips in the x-/y- and/or z-directions;
- separating signal contributions from water and fat and estimating a Bo map and/or an apparent transverse relaxation time map ($T_2$* map) using a Dixon algorithm; and
- synthesizing an image of a specified contrast from the echo signal data, the Bo map and/or the $T_2$* map.

2. Method of claim 1, wherein the rotation angle of the radial or spiral k-space trajectories is incremented during acquisition by the golden angle.

3. Method of claim 1 or 2, wherein the phase-encoding of the echo signals is varied in the z-direction and/or the rotation angle of the radial or spiral k-space trajectories is incremented in the $k_x$-/$k_y$-directions.

4. Method of any one of claims 1-3, wherein the sampling density in the $k_x$-/$k_y$-directions varies as a function of $k_z$ such that a central portion of k-space is sampled more densely than the peripheral portions.

5. Method of any one of claims 1-4, wherein one or more shots of the multi-echo acquisition is used to extract an intrinsic image navigation signal which is used for motion correction.

6. Method of any one of claims 1-5, wherein a single echo image is reconstructed from the acquired echo signal data for each echo time.

7. Method of any one of claims 1-6, wherein a k-space weighted image contrast (KWIC) filter is used for reconstructing the single echo images.

8. Method of any one of claims 1-7, wherein compressed sensing is used for reconstructing the single echo images or within the water/fat separation.

9. Method of any one of claims 1-8, wherein a subset of the echo signals is generated at an ultra-short echo time (UTE).

10. Method any one of claims 1-9, wherein synthesizing the image of a specified contrast involves:

   - computing a zero echo time magnitude image from the acquired echo signal data and
   - applying a weighting to each voxel of the zero echo time magnitude image, which weighting is derived from the $T_2$* map.

11. Method of any one of claims 1-10, wherein the imaging sequence is a field echo sequence or a spin echo sequence.

12. Method of any one of claims 1-11, wherein motion of the object (10) is detected during the acquisition of the echo signals, wherein a corresponding motion-compensation is applied in the step of reconstructing the single echo images, in the step of separating the signal contributions from water and fat, or in the step of synthesizing the image of a specified contrast.

13. Method of claim 1-12, wherein the synthesized image resembles an image which is generated by

   - magnitude reconstruction of single echo images from the acquired echo signal data and
   - combination of the single echo images by a sum of squares algorithm.

14. Method of any one of claims 1-13, wherein a flow map is derived from the acquired echo signal data, wherein the flow map is used in the step of synthesizing the image.

15. MR device including at least one main magnet coil (2) for generating a uniform, steady magnetic field Bo within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17) for reconstructing MR images from the received MR signals, wherein the MR device (1) is arranged to perform the following steps:

- subjecting the object (10) to an imaging sequence comprising RF excitation pulses and switched magnetic field gradients, wherein multiple echo signals are generated at different echo times after each RF excitation pulse,
- acquiring the echo signal data along radial or spiral k-space trajectories, wherefore the imaging sequence comprises magnetic field gradient blips in the x-/y- and/or z-directions;
- separating signal contributions from water and fat to the echo signals and estimating a Bo map and/or an apparent transverse relaxation time map ($T_2$* map) using a Dixon algorithm; and
- synthesizing an image of a specified contrast from the echo signal data, the Bo map and/or the $T_2$* map.

16. Computer program to be run on a MR device, which computer program comprises instructions for:

- generating an imaging sequence comprising RF excitation pulses and switched magnetic field gradients, wherein multiple echo signals are generated at different echo times after each RF excitation pulse,
- acquiring the echo signal data along radial or spiral k-space trajectories, wherefore the imaging sequence comprises magnetic field gradient blips in the x-/y- and/or z-directions;
- separating signal contributions from water and fat to the echo signals and estimating a Bo map and/or an apparent transverse relaxation time map ($T_2$* map) using a Dixon algorithm; and
- synthesizing an image of a specified contrast from the echo signal data, the Bo map and/or the $T_2$* map.

**Fig. 1**

**Fig. 2**

**Fig. 3**

Fig. 4

Europäisches
Patentamt

European
Patent Office

Office européen
des brevets

# EUROPEAN SEARCH REPORT

Application Number

EP 18 15 8035

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | THOMAS BENKERT ET AL: "Free-breathing volumetric fat/water separation by combining radial sampling, compressed sensing, and parallel imaging", MAGNETIC RESONANCE IN MEDICINE., vol. 78, no. 2, 9 September 2016 (2016-09-09), pages 565-576, XP055493625, US ISSN: 0740-3194, DOI: 10.1002/mrm.26392 * page 566 - page 569; figure 1 * | 1-16 | INV. G01R33/24 G01R33/44 G01R33/48 G01R33/50 G01R33/561 G01R33/565 ADD. G01R33/563 G01R33/567 |
| A | US 2017/322274 A1 (BOLSTER JR BRADLEY DRAKE [US] ET AL) 9 November 2017 (2017-11-09) * the whole document * | 1-4,7, 15,16 | |
| A | DU ET AL: "Two-dimensional ultrashort echo time imaging using a spiral trajectory", MAGNETIC RESONANCE IMAGING, ELSEVIER SCIENCE, TARRYTOWN, NY, US, vol. 26, no. 3, 21 December 2007 (2007-12-21), pages 304-312, XP022511966, ISSN: 0730-725X, DOI: 10.1016/J.MRI.2007.08.005 * the whole document * | 1,9,15, 16 | |

TECHNICAL FIELDS
SEARCHED      (IPC)

G01R

-/--

The present search report has been drawn up for all claims

| Place of search | Date of completion of the search | Examiner |
|---|---|---|
| Munich | 20 August 2018 | Raguin, Guy |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

## EUROPEAN SEARCH REPORT

Application Number

EP 18 15 8035

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | NEEB H ET AL: "A new method for fast quantitative mapping of absolute water content in vivo", NEUROIMAGE, ELSEVIER, AMSTERDAM, NL, vol. 31, no. 3, 1 July 2006 (2006-07-01), pages 1156-1168, XP024906405, ISSN: 1053-8119, DOI: 10.1016/J.NEUROIMAGE.2005.12.063 [retrieved on 2006-07-01] * the whole document * ----- | 9,10 | |
| A | NITZ W R: "FAST AND ULTRAFAST NON-ECHO-PLANAR MR IMAGING TECHNIQUES", EUROPEAN RADIOLOGY, SPRINGER INTERNATIONAL, BERLIN, DE, vol. 12, no. 12, 1 December 2002 (2002-12-01), pages 2866-2882, XP001199867, ISSN: 0938-7994 * page 2870 - page 2871; figure 10 * ----- | 13 | |
| A | B NEWLING ET AL: "Chemically resolved NMR velocimetry", CHEMICAL ENGINEERING SCIENCE, vol. 52, no. 13, 1 July 1997 (1997-07-01), pages 2059-2072, XP055493726, GB ISSN: 0009-2509, DOI: 10.1016/S0009-2509(97)00034-1 * the whole document * ----- | 14 | TECHNICAL FIELDS SEARCHED (IPC) |

-/--

The present search report has been drawn up for all claims

| Place of search | Date of completion of the search | Examiner |
|---|---|---|
| Munich | 20 August 2018 | Raguin, Guy |

EPO FORM 1503 03.82 (P04C01)

page 2 of 3

Europäisches
Patentamt

European
Patent Office

Office européen
des brevets

**EUROPEAN SEARCH REPORT**

Application Number

EP 18 15 8035

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | SONG HK ET AL: "k-space weighted image contrast (KWIC) for contrast manipulation in projection reconstruction MRI", MAGNETIC RESONANCE IN MEDICINE, JOHN WILEY & SONS, INC, US, vol. 44, no. 6, 1 December 2000 (2000-12-01), pages 825-832, XP002333653, ISSN: 0740-3194, DOI: 10.1002/1522-2594(200012)44:6<825::AID-MRM2>3.0.CO;2-D * the whole document * ----- | 7 | |

TECHNICAL FIELDS
SEARCHED (IPC)

The present search report has been drawn up for all claims

| Place of search | Date of completion of the search | Examiner |
|---|---|---|
| Munich | 20 August 2018 | Raguin, Guy |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 18 15 8035

This annex lists the patent family members relating to the patent documents cited in  the above-mentioned European search report.
The members are as contained in the European Patent Office EDP file on
The European Patent Office is in no way liable for these particulars which are merely given for the purpose of information.

20-08-2018

| Patent document cited in search report | Publication date | Patent family member(s) | Publication date |
|---|---|---|---|
| US 2017322274    A1 | 09-11-2017 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ALTBACH et al.** Radial Fast Spin-Echo Method for T2-Weighted Imaging and T2 Mapping of the Liver. *J. Magn. Reson. Imaging,* 2002, vol. 16, 179-189

- **SONG et al.** *Magn. Reson. Med.,* 2000, vol. 44, 825-832
- **BERKER et al.** *J. Nucl. Med.,* 2012, vol. 53, 796-804